# FASCICULE DE BREVET EUROPEEN

(11) **EP 3 111 467 B1**
(45) Date de publication et mention de la délivrance du brevet: **03.04.2024**
(21) Numéro de dépôt: 15706806.5
(22) Date de dépôt: 26.02.2015
(51) Int. Cl.: H01L 21/60, H01L 21/98, H01L 23/485

(54) **PROCEDE DE REALISATION D'UNE STRUCTURE PAR ASSEMBLAGE D'AU MOINS DEUX ELEMENTS PAR COLLAGE DIRECT**
VERFAHREN ZUR HERSTELLUNG EINER STRUKTUR DURCH ANORDNUNG VON MINDESTENS ZWEI ELEMENTEN DURCH DIREKTE ADHÄSIVE VERBINDUNG
PROCESS FOR PRODUCING A STRUCTURE BY ASSEMBLING AT LEAST TWO ELEMENTS BY DIRECT ADHESIVE BONDING

(30) Priorité: 27.02.2014 FR 1451602
(43) Date de publication de la demande: 04.01.2017
(73) Titulaire: Commissariat à l'Énergie Atomique et aux Énergies Alternatives, 75015 Paris (FR)
(72) Inventeur: GONDCHARTON, Paul, F-38100 Grenoble (FR); BENAISSA, Lamine, F-91300 Massy (FR); IMBERT, Bruno, F-38000 Grenoble (FR); MORICEAU, Hubert, F-38120 Saint-Egreve (FR)
(74) Mandataire: Brevalex
(86) Numéro de dépôt international: PCT/EP2015/053984
(87) Numéro de publication internationale: WO 2015/128399

(56) Documents cités:
- FR-A1- 2 947 481
- FR-A1- 2 963 158
- FR-A1- 2 969 814
- US-A- 5 972 179
- US-A1- 2012 094 469
- US-A1- 2012 241 961
- US-B1- 6 303 490
- US-B1- 6 562 715
- US-B2- 6 812 143
- "8.3 Copper Interconnect Processing" In: Krishna Seshan: "Hanbook of Thin Film Deposition", 19 juillet 2012 (2012-07-19), Elsevier, XP55195181, ISBN: 9781437778731 page 234, page 234
- CHO J ET AL: "Mechanism of low-temperature copper-to-copper direct bonding for 3D TSV package interconnection", 34<TH> ELECTRONIC COMPONENTS CONFERENCE, IEEE, 28 mai 2013 (2013-05-28), pages 1133-1140, XP032474322, ISSN: 0569-5503, DOI: 10.1109/ECTC.2013.6575716 ISBN: 978-1-4799-0233-0 [extrait le 2013-08-06]
- CHEN K N ET AL: "Microstructure evolution and abnormal grain growth during copper wafer bonding", APPLIED PHYSICS LETTERS, AMERICAN INSTITUTE OF PHYSICS, US, vol. 81, no. 20, 11 novembre 2002 (2002-11-11), pages 3774-3776, XP012032510, ISSN: 0003-6951, DOI: 10.1063/1.1521240
- CHO J ET AL: "Mechanism of low-temperature copper-to-copper direct bonding for 3D TSV package interconnection", PROCEEDINGS OF THE 27 TH ELECTRONIC COMPONENTS CONFERENCE (7TH ELECTRONIC COMPONENTS CONFERENCE, STOUFFER'S NATIONAL CENTER INN, ARLINGTON, VA., MAY 16-18, 1977), INSTITUTE OF ELECTRICAL AND ELECTRONICS ENGINEERS, 28 May 2013 (2013-05-28), pages 1133-1140, XP032474322, ISSN: 0569-5503, DOI: 10.1109/ECTC.2013.6575716 [retrieved on 2013-08-06]

## Description

### DOMAINE TECHNIQUE ET ART ANTÉRIEUR

La présente invention se rapporte à un procédé de réalisation d'une structure par assemblage d'au moins deux éléments par collage direct, la surface à assembler de chaque élément comprenant au moins une portion en cuivre, le procédé permettant d'obtenir un renforcement de l'énergie de fracture de la structure.

L'intégration en trois dimensions dans les dispositifs microélectroniques et nanoélectroniques permet de réduire la taille des dispositifs, de réduire leur consommation électrique, d'augmenter les vitesses de transmission, les performances, la fréquence de fonctionnement.

Une intégration en trois dimensions peut comporter notamment les étapes de collage avec alignement des plots de connexion, d'amincissement et d'interconnexion verticale à travers l'empilement au moyen de vias de connexion. Cependant pour obtenir une densité d'interconnexion élevée et pour simplifier la technologie, il est préférable d'assembler les éléments, et en particulier les connexions par un collage métal-métal.

Par exemple le cuivre est un des métaux particulièrement utilisés pour réaliser des plots de connexion.

Différentes techniques de collage métal-métal existent, basées notamment sur un collage direct c'est-à dire un collage sans apport de matière adhésive. Parmi ces techniques, la thermocompression consiste à mettre les éléments en contact l'un avec l'autre, à appliquer une pression uniaxiale de part et d'autre de l'assemblage et à chauffer l'empilement. La pression requise est de l'ordre du MPa et une température supérieure à 250°C est nécessaire pour obtenir un collage présentant une forte tenue mécanique. L'inconvénient de cette technique est la mise en oeuvre de température élevée (supérieures à 250°C) qui peuvent être incompatibles avec certaines structures assemblées.

Une autre technique consiste à la mise en contact de surfaces métalliques sous ultra vide après une activation par bombardement ionique des surfaces. Cette étape permet l'assemblage de substrats dès la température ambiante sous compression mais nécessite un environnement de collage en ultravide difficilement utilisable en industrie.

Le document FR 2969814 divulgue un procédé de collage direct comportant des plots de collage en cuivre dopé.

Il existe une autre technique décrite dans le document FR 2947481 comportant une étape d'activation des surfaces par polissage mécano-chimique et nettoyage. Les surfaces mises en contact présentent une rugosité RMS inférieures à 1 nm et sont hydrophiles. Le collage peut ainsi s'effectuer à température ambiante, sous pression atmosphérique notamment à l'air et sans pression uniaxiale au moment de la mise en contact des plaques.

Cependant l'assemblage ainsi obtenu offre une énergie de fracture faible après le collage (typiquement inférieure à 1 J/m²). Afin d'atteindre une énergie de fracture suffisante, compatible avec les procédés d'intégration de circuits de la microélectronique, le packaging de MEMS (comprenant par exemple de la découpe en puce, de l'amincissement mécanique, ...), les assemblages doivent être stockés jusqu'à plusieurs mois à température ambiante. Une durée de stockage aussi longue n'est pas envisageable dans le cadre d'une exploitation industrielle, en particulier dans le domaine de la microélectronique.

Il est connu que la qualité du collage direct entre des couches en cuivre est influencée par l'orientation cristallographique des grains desdites couches (voir par exemple le document "Mechanism of low-temperature copper-to-copper direct bonding for 3D TSV package interconnection", J.Cho et al, Proceeding of the IEEE 63rd Electronic componentes and technology conférence, 28-31 mai 2013, pages 1133-1140). Il est aussi connu que l'orientation cristallographique des grains d'une couche en cuivre, qui a été déposée sur une couche de croissance, peut être déterminée au moins en partie par les conditions de dépôt de la couche de croissance (voir par exemple US 6303490 B1, US 6562715 B1 et US 6812143 B2).

### EXPOSÉ DE L'INVENTION

C'est par conséquent un but de la présente invention d'offrir un procédé de réalisation d'une structure par assemblage d'au moins deux éléments par collage direct, dans lequel la cinétique de renforcement de l'énergie de fracture est favorisée dès la température ambiante.

On entend par "renforcement de l'énergie de fracture", l'augmentation de l'énergie nécessaire à fournir pour séparer les deux éléments assemblés par collage direct. En favorisant la cinétique de renforcement de l'énergie de fracture, on accélère l'augmentation de l'énergie de fracture par rapport aux procédés de l'état de la technique.

Le but précédemment énoncé est atteint par un procédé de réalisation d'une structure par assemblage d'au moins deux éléments par collage direct, comportant la réalisation des éléments et l'assemblage des éléments.

La réalisation des éléments comprend les étapes définies par les revendications ci-jointes, telles que _{:}
- dépôt sur un substrat semi-conducteur d'au moins une portion d'un matériau donné par dépôt physique en phase vapeur formant une portion de croissance, le matériau donné étant choisi parmi TiNₓ et TaNₓ,
- dépôt sur la portion de matériau donné d'au moins une portion de cuivre.

Les conditions de dépôt de la portion de croissance par dépôt physique en phase vapeur sont telles que la couche de cuivre présente une orientation cristallographique principalement en (220).

L'assemblage des éléments comporte les étapes:
- polissage des surfaces des éléments comportant la portion de cuivre de sorte à ce qu'elles présentent une rugosité inférieure à 1 nm RMS et des propriétés hydrophiles,
- mise en contact des deux surfaces,
- stockage à basse temperératures entre 0ºC et 100ºC.

Grâce à l'étape de dépôt physique en phase vapeur de la portion de croissance, le cuivre déposé sur cette portion favorise la cinétique de renforcement de l'énergie de fracture dès la température ambiante.

On entend par dépôt physique en phase vapeur notamment la pulvérisation cathodique (« sputtering » en terminologie anglo-saxonne), le dépôt cathodique à arc (« cathodic arc deposition » en terminologie anglo-saxonne), le dépôt physique sous faisceau d'électrons ou d'ions (« electron beam physical vapor deposition » en terminologie anglo-saxonne), l'évaporation (« evaporative deposition » en terminologie anglo-saxonne) ou le dépôt par laser pulsé (« pulsed laser deposition » en terminologie anglo-saxonne).

En effet, les inventeurs ont constaté que le choix d'une technique de dépôt particulière i.e. le dépôt physique en phase vapeur, et de conditions particulières, pour former une couche de matériau spécifique sur laquelle une couche de cuivre va être déposée et croître, permettait à la couche de cuivre de croître selon une cristallinité préférentielle qui permet de renforcer l'énergie de fracture à température ambiante selon une cinétique plus rapide qu'avec les procédés de l'état de la technique et dans des conditions beaucoup moins contraignantes.

Selon l'invention, la couche de cuivre formée sur la couche de matériau spécifique présente un rapport entre l'intensité du pic représentatif de l'orientation (220) et l'intensité du pic représentatif de l'orientation (111) supérieur ou égal à 0,5.

Selon l'invention, le dépôt physique en phase vapeur se fait à une température comprise entre 20ºC et 100ºC.

Par ailleurs, le collage peut avantageusement avoir lieu sous air, à température ambiante et sans application d'une pression entre les deux éléments assemblés.

Ainsi on obtient grâce à l'invention une structure offrant une énergie de rupture renforcée, plus rapidement et plus simplement.

Avantageusement la portion de cuivre est déposée par dépôt physique en phase vapeur.

La présente invention a alors pour objet un procédé de réalisation d'une structure par collage direct de deux éléments défini par les revendications ci-jointes.

Avantageusement, les conditions de dépôt de la portion de croissance par dépôt physique en phase vapeur sont telles que la première portion de cuivre a une croissance favorisant les plans peu denses tels que les plans des familles (110) et (100).

Le matériau de la portion de croissance peut être du TiN.

En variante, on peut prévoir qu'au moins une deuxième portion de cuivre soit formée sur la première portion de cuivre d'au moins un des éléments. La deuxième portion de cuivre peut être formée par dépôt électrochimique, par dépôt atomique, par dépôt physique en phase vapeur, par dépôt chimique en phase vapeur.

Le procédé peut comporter une étape d'incorporation d'au moins une espèce chimique dans ou sur la première ou deuxième couche de cuivre. La au moins une espèce chimique peut être choisie parmi le bore et/ou du carbone, et/ou du phosphore et/ou du soufre et /ou du chlore et/ou de l'oxygène.

L'incorporation d'au moins une espèce chimique peut se faire par dépôt par implantation ionique ou par diffusion assisté on non thermiquement.

En variante, l'incorporation d'au moins une espèce chimique peut avoir lieu pendant le polissage

La deuxième portion de cuivre peut être formée par dépôt électrochimique et l'incorporation d'espèce peut se faire avantageusement lors du dépôt électrochimique.

Le collage peut se faire avec un degré d'humidité au moins égale à 20%.

De manière avantageuse, le stockage se fait à une température comprise entre 75°C et 100°C.

La structure peut être une structure microélectronique et/ou nanoélectronique, les portions de cuivre formant par exemple des vias d'interconnexion.

### BRÈVE DESCRIPTION DES DESSINS

La présente invention sera mieux comprise sur la base de la description qui va suivre et des dessins en annexe sur lesquels:
- les figures 1A à 1C représentent schématiquement les étapes de réalisation d'un élément en vue de son assemblage par collage direct avec un autre élément réalisé de manière similaire,
- les figures 2A à 2C montrent différentes structures obtenues avec le procédé selon l'invention,
- la figure 3 montre la variation de l'énergie de fracture en mJ/m² en fonction du temps en jours pour une structure réalisée selon l'invention et des structures réalisées suivant les procédés de l'état de la technique,
- la figure 4 montre une représentation schématique d'une structure obtenue avec le procédé selon l'invention, la structure comportant des portions de cuivre, de diélectrique et de semi-conducteur au niveau des faces d'assemblage.

### EXPOSÉ DÉTAILLÉ DE MODES DE RÉALISATION PARTICULIERS

Le procédé selon la présente invention consiste à réaliser un assemblage par un collage direct entre une première et une deuxième surfaces, les surfaces pouvant comprendre par exemple uniquement du cuivre, ou au moins la première surface comprenant au moins une portion de cuivre et au moins une portion d'un autre matériau, par exemple un matériau diélectrique, par exemple du SiO₂, la deuxième surface étant uniquement en cuivre ou comprenant au moins une portion de cuivre et au moins une portion d'un autre matériau, par exemple un matériau diélectrique, ou encore la première surface comprenant au moins une portion de cuivre délimitée par au moins une portion de matériau diélectrique au sein de portions d'un troisième matériau, par exemple un matériau semi-conducteur, la deuxième surface pouvant être uniquement en cuivre ou de structure similaire à la première surface.

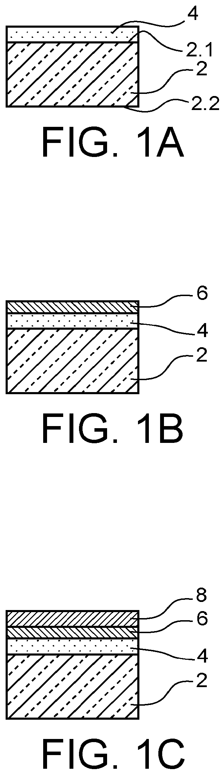

Sur les figures 1A à 1C, on peut voir des étapes de réalisation d'un élément destiné à être assemblé par collage direct avec un élément réalisé suivant les mêmes étapes.

Sur la figure 1A, on peut voir un substrat 2 en matériau semi-conducteur, par exemple en silicium, par exemple dopé p, comprenant une face avant 2.1 et une face arrière 2.2. La face avant 2.1 du substrat 2 est recouverte d'une couche d'oxyde thermique 4, dans l'exemple du SiOz, par exemple ayant une épaisseur comprise entre 5 et 5000 nm, par exemple égale à 200 nm. En variante, la couche d'oxyde peut être omise. Lors d'une première étape, une couche d'un matériau donné 6 est formée sur l'oxyde thermique par dépôt physique en phase vapeur (PVD pour "physical vapor deposition"). En variante, une ou des couches spécifiques, notamment des couches d'accroche, peuvent être prévues sous la couche 6, par exemple en Ti.

La couche 6 sert de base à la croissance d'une couche de cuivre qui présentera une cristallinité telle qu'elle favorise le renforcement de l'énergie de fracture de l'assemblage dès la température ambiante entre deux éléments comportant chacun une telle couche de cuivre. En outre, elle permet d'éviter les problèmes de diffusion du cuivre dans le silicium sous-jacent et d'adhérence de la couche déposée.

On cherche à obtenir une croissance particulière du cuivre favorisant les plans peu denses notamment les familles de plans (110) ou (100), i.e. la famille de plans {110} comprend les plans (110), (101) et (011) et les plans dont les indices sont des multiples des indices des plans précédents, par exemple (-110), (220), (330), (202), (022)..., et la famille de plans {100} comprend les plans (010), (001) et les plans dont les indices sont des multiples des indices des plans précédents, par exemple (-100), (020), (030), (003), (002).

Cette orientation préférentielle des grains de cuivre de la couche polycristalline selon des plans cristallins peu denses favorise une cinétique d'oxydation métallique rapide.

Il a été constaté que la cinétique d'oxydation métallique rapide est favorisée lorsque le rapport d'intensité des pics (220) et (111) obtenus par diffraction RX est supérieur ou égal 0,5. On considère le pic (220) car c'est celui qui est le plus facile à observer et qui présente l'amplitude la plus importante.

Pour le cuivre, l'orientation (220) est la plus propice.

La couche 6 sera désignée par la suite "couche de croissance". Le matériau de la couche de croissance est choisi par le nitrure de titane TiNx et le nitrure de tantale TaNx. De manière préférée, la couche de croissance est en TiN.

Le dépôt PVD de la couche de croissance se fait à basse température entre 20°C et 100°C, voire entre 20°C et 50°C, i.e. à température ambiante ou quasiment à température ambiante.

La couche de croissance 6 a une épaisseur comprise entre 5 nm et 100 nm par exemple une épaisseur comprise entre 10 nm et 60 nm, par exemple égale à 20 nm.

La couche de croissance peut également servir de barrière de diffusion du cuivre dans le silicium, ce qui permet un degré d'intégration élevé. Dans l'art antérieur les couches de croissance utilisées (déposées à plus de 250°C) sont choisies de sorte à privilégier une croissance du cuivre suivant l'orientation (111) ce qui confère à la couche de cuivre de meilleures propriétés de tenue à l'électromigration.

Le dépôt de la couche de croissance 6 peut être réalisé par exemple par sputtering en mode de puissance DC ou RF dans une gamme de puissance de 5 kW à 30 kW (par exemple 8 kW DC), à une température comprise entre 20°C et 250°C (par exemple 20°C), avec des débits d'argon et de diazote compris entre 8,44·10⁻³ et 337,8·10⁻³ Pa m³/s (5 sccm et 200 sccm), par exemple 76·10-3 Pa m³/s (45 sccm) d'Ar et 143,56·10-3 Pa m³/s (85 sccm) de N₂.

L'élément ainsi obtenu est représenté sur la figure 1B.

Lors d'une étape suivante, on forme une couche de cuivre 8 sur la couche de croissance 6. De préférence, la couche de cuivre 8 est formée par dépôt physique en phase vapeur. Ainsi il est possible de former la couche de cuivre 8 sans remise à l'air de l'élément. En effet, il est possible d'utiliser le même bâti de PVD pour le dépôt de la couche de croissance 6 et le dépôt de la couche de cuivre 8. Alternativement la couche de cuivre peut être déposée par dépôt chimique en phase vapeur (CVD pour "chemical phase deposition" en terminologie anglo-saxonne).

La couche 8 présente une épaisseur de préférence comprise entre 10 nm et 1 µm, par exemple égale à 500 nm. Le dépôt par voie physique de la couche de cuivre pourra être réalisé par exemple en mode DC à une puissance comprise entre 0,5 kW et 30 kW (par exemple 3 kW) à des températures comprises entre 20°C et 400°C, par exemple à 20°C, et sous des débits d'argon de 5 à 200 sccm (par exemple 50 sscm).

Pour le dépôt de la couche de cuivre par voie chimique, la température sera comprise entre 200°C et 400°C, par exemple 200°C, sous des pressions totales de gaz inertes et précurseurs comprises entre 0,5 mTorr et 2 mTorr, par exemple 1,15 mTorr, et sous flux d'hélium, de dihydrogène, de diazote et de gaz précurseurs connus de l'homme du métier et commercialisés par les équipementiers Applied Materials ou Alliance Concept par exemple.

L'élément E1 ainsi obtenu est représenté sur la figure 1C. De préférence, un recuit a ensuite lieu pour stabiliser la microstructure des couches.

Un deuxième élément E2 est réalisé suivant les étapes décrites sur les figures 1A à 1C.

Chaque élément E1, E2 comporte donc en face avant une couche de cuivre 8, 108 présentant une cristallinité préférentielle en (220).

Lors d'une étape suivante, une étape de polissage des faces avant a lieu de sorte à obtenir une rugosité inférieure à 1 nm RMS (Root Mean Square), avantageusement inférieure à 0,5 nm RMS. La mesure de la rugosité est réalisée par AFM sur des scans de 1×1µm². Cette étape de polissage est réalisée par exemple par polissage mécano-chimique. En outre les surfaces présentent une surface hydrophile. Dans la présente demande, une surface est considérée comme hydrophile si l'angle de contact entre une goutte d'eau et la surface est compris entre 0° et 20°, de préférence le plus faible possible.

De préférence, les surfaces sont nettoyées afin de supprimer les particules dues au polissage et la majeure partie des inhibiteurs de corrosion. Ce nettoyage peut consister par exemple en un brossage sous chimie basique.

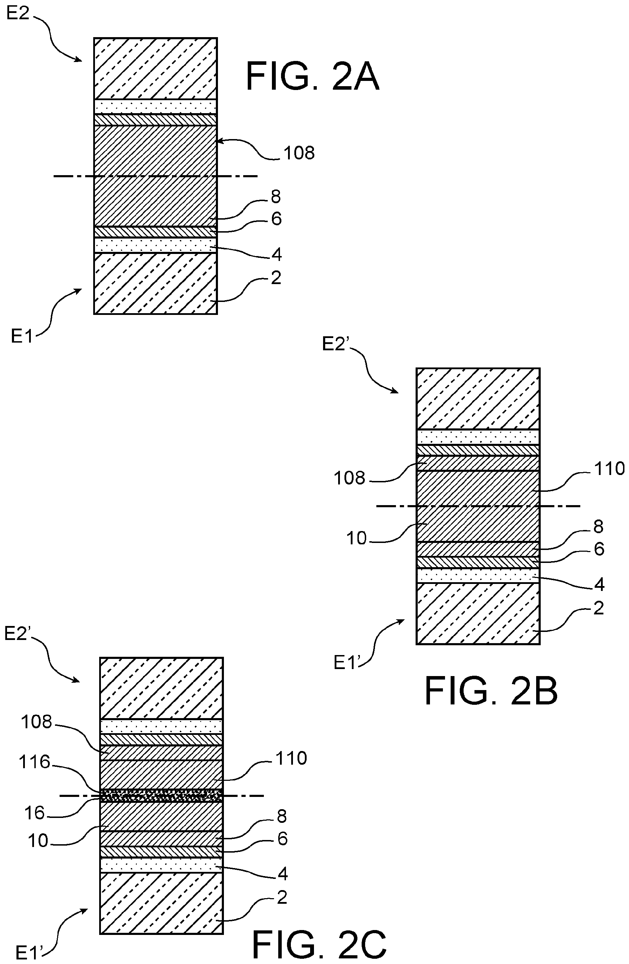

Lors d'une étape suivante représentée sur la figure 2A, les deux éléments E1, E2 sont mis en contact par leur surface avant à basse température (typiquement comprise entre 5°C et 50°C, et typiquement de l'ordre de 15° à 25°C), sous atmosphère humide, avantageusement sous air, avec une degré d'humidité avantageusement supérieur à 20%, par exemple 40% qui correspond au degré d'humidité dans une salle blanche de l'industrie microélectronique. L'atmosphère lors du collage direct peut avantageusement être enrichie en oxygène ou en vapeur d'eau. Ces conditions de collages sont choisies pour ne pas altérer les propriétés de surface (rugosité, hydrophilie, etc.) permettant le mécanisme d'adhésion par collage direct tel que définies ci-dessus.

De préférence, le collage est réalisé relativement rapidement après le polissage et le nettoyage, de préférence dans les 120 minutes suivant le nettoyage, de manière encore préférée dans les 20 minutes suivant le nettoyage.

La structure ainsi obtenue est représentée sur la figure 2A, l'interface de collage étant symbolisée par un trait en pointillé.

Après mise en contact la structure est stockée plusieurs jours, voire plusieurs semaines à basse température pour permettre à l'interface de collage direct d'atteindre une énergie de fracture suffisante.

Dans la présente demande, on entend par "basse température" pour le stockage, une température comprise entre 0 °C et 100°C et typiquement autour de la température ambiante entre 15 et 30°C.

Lors du stockage, l'énergie de fracture cuivre-cuivre est renforcée du fait d'un mécanisme d'oxydation métallique au niveau de l'interface de collage. Le renforcement se fait par diffusion du cuivre à travers sa couche d'oxyde ce qui provoque, du fait de la présence de l'eau des surfaces hydrophiles en contact, une oxydation. Cette oxydation induit alors l'augmentation d'épaisseur de la couche d'oxyde interfaciale. Les inventeurs ont remarqué que les orientations particulières des couches de cuivre obtenues par croissance sur une couche de croissance déposée par PVD étaient propices à la diffusion rapide du cuivre à travers son oxyde ce qui conduit à une cinétique d'oxydation plus rapide et donc à un renforcement à température ambiante lui aussi plus rapide.

Pour illustrer le gain, différentes structures S1 à S4 ont été réalisées. Pour contrôler la cristallinité de la couche de cuivre obtenue pour ces différentes structures, on a calculé les rapports des intensités des pics représentatifs de l'orientation (220) et (111) de la couche de cuivre obtenus par diffraction RX pour différents éléments. Ces pics observés sont référencés pour les standards de diffraction de poudre dans le fichier JCPDS Copper file No. 04-0836. Ces pics sont ceux de la couche de cuivre 8.

La structure S1 correspond à un assemblage obtenu par collage de deux plaques comportant un dépôt chimique en phase vapeur métallo-organique (MOCVD "Metallo-Organic Chemical Vapor Deposition" en terminologie anglo-saxonne) de nitrure de titane TiN de 20 nm d'épaisseur suivi d'un dépôt de cuivre Cu pulvérisé par PVD de 500 nm d'épaisseur post polissage. Le rapport obtenu pour cette structure est de 0,23.

La structure S2 correspond à l'assemblage obtenu par le collage de deux plaques comportant un dépôt MOCVD de nitrure de titane TiN de 20 nm d'épaisseur suivi d'un dépôt de cuivre Cu pulvérisé par PVD de 200 nm d'épaisseur et d'un dépôt électrochimique de 800 nm d'épaisseur, ramené à 500 nm d'épaisseur après polissage. Le rapport obtenu pour cette structure est de 0,39.

Pour les structures S1 et S2, le rapport d'intensité (220) sur (111) est strictement inférieur à 0,5 : le cuivre déposé sur du TiN déposé par CVD a ainsi une orientation majoritairement (111).

La structure S3 correspond à l'assemblage obtenu par le collage de deux plaques comportant un dépôt PVD dans les conditions de température mentionnées ci-dessus de nitrure de titane TiN de 20 nm d'épaisseur suivi d'un dépôt de cuivre Cu pulvérisé par PVD de 1000 nm d'épaisseur, ramené à 500 nm d'épaisseur après polissage. Le rapport obtenu pour cette structure est de 9,35.

La structure S4 correspond à l'assemblage obtenu par le collage de deux plaques comportant un dépôt PVD de nitrure de titane TiN de 20 nm d'épaisseur suivi d'un dépôt de cuivre Cu pulvérisé par PVD de 200 nm d'épaisseur et d'un dépôt électrochimique de cuivre de 800 nm d'épaisseur, ramené à 500 nm d'épaisseur après polissage. Le rapport obtenu pour cette structure est de 0,67.

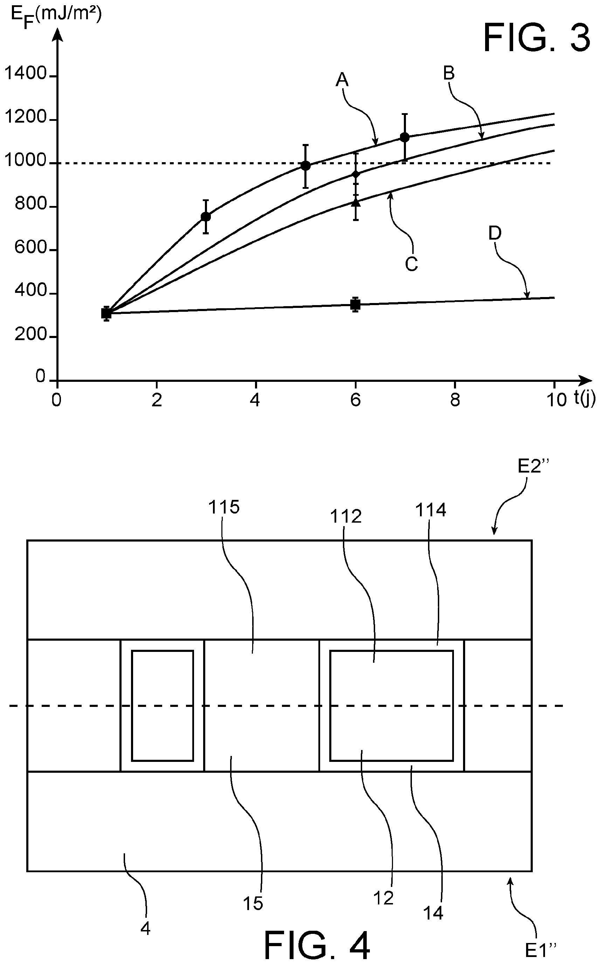

Les couches de cuivre 8 selon les structures S3 et S4 présentent des rapports d'intensité (220) sur (111) supérieurs ou égaux à 0,5, correspondant à une orientation préférentielle (220) ou toute orientation correspondante décrite ci-dessus. Comme on le verra en lien avec la figure 3, cette orientation améliore la cinétique de renforcement de l'énergie de fracture cuivre-cuivre à température ambiante.

Toutes ces structures S1, S2, S3 et S4 ont ensuite été stockées à température ambiante.

Sur la figure 3, on peut voir la variation de l'énergie de fracture E_{F} en mJ/m² en fonction du temps t en jours pour des structures réalisées selon l'invention (courbes A et B qui correspondent respectivement aux structures S4 et S3) et des structures de l'état de la technique, la courbe C correspond à l'énergie de fracture de la structure S1 et la courbe D correspond à l'énergie de fracture de la structure S2.

Les énergies de fracture ont été mesurées par la technique du DCB (Double Cantilever Beam encore connu sous le terme de technique d'insertion de lame) à partir de la longueur de décollement après insertion d'une lame au niveau de l'interface de collage.

On constate que l'énergie de fracture de la structure obtenue selon l'invention (courbe A et B) atteint l'énergie de fracture de 1000 mJ/m² (tenue mécanique minimale compatible avec les procédés d'intégration) en moins de temps que celles obtenues par des procédés de l'état de l'art (courbe C et D).

Le stockage peut avoir lieu à température ambiante, mais de manière avantageuse, un traitement thermique à basse température peut avoir lieu pendant ce stockage, par exemple entre 75°C et 100°C, ce qui accélère la cinétique de renforcement de la fermeture de l'interface et diminue donc le temps de stockage de l'assemblage. Typiquement, un stockage à 100°C peut faire diminuer le temps de stockage de 50% au minimum.

L'atmosphère de stockage n'a que peu d'influence. Il pourra s'agir d'un stockage à l'air.

De manière très avantageuse, une ou des espèces propices à la diffusion rapide du cuivre à travers son oxyde surfacique et donc à la cinétique de renforcement de l'énergie de fracture à température ambiante peuvent être incorporées dans la ou sur la couche de cuivre 8, en surface de la couche de cuivre 8, ce qui permet de contrôler la vitesse de renforcement de l'énergie de fracture. Il peut s'agir par exemple d'une couche de cuivre déposée de façon électrolytique (ECD) sur la couche de cuivre déposée par voie physique et ayant l'orientation préférentielle (220) selon un ratio de pics défini précédemment supérieure ou égale à 0,5. En variante, l'espèce est incorporée par implantation ionique, par exemple en utilisant une énergie comprise entre 10 keV et 200 keV et la dose implantée est par exemple comprise entre 10¹⁴ et 10¹⁷ atomes/cm². Les espèces additionnelles peuvent être par exemple du bore, du carbone, du phosphore du soufre, du chlore ou de l'oxygène.

En variante, le bore peut être incorporé par diffusion pour une dose totale de bore est égale à 5.10¹⁵ atomes/cm². Cette diffusion pourra être réalisée par exemple à l'aide d'un premier dépôt CVD sous flux de B₂H₆ puis par un recuit de diffusion à des températures comprises entre 200 et 600°C.

En variante encore, ces espèces peuvent être intégrées à la solution chimique mélange chimique, également appelé slurry en terminologie anglo-saxonne destiné au polissage mécano-chimique.

Sur les figures 2B et 2C, on peut voir un autre exemple de réalisation d'éléments E1', E2' en vue de leur assemblage par collage direct.

Dans cet exemple de réalisation, une deuxième couche de cuivre 10, 110 est déposée sur la couche de cuivre 8, 108 qui forme alors une couche de germination de chaque élément E1', E2'. Par exemple, la deuxième couche de cuivre 10, 10 est formée par dépôt électrochimique. L'épaisseur de la couche 8 peut être comprise entre 50 nm et 5000 nm, et est par exemple de l'ordre de 200 nm, et l'épaisseur de la couche 10 peut être comprise entre 50 nm et 50 µm, et est par exemple égale à 300 nm.

La couche 10 de cuivre présente, elle aussi, une cristallinité qui permet d'avoir une cinétique de renforcement de l'énergie de fracture de l'assemblage plus rapide, du fait de la présence d'impuretés liées à ce type de couche favorisant la diffusion du cuivre, etc.

La réalisation d'une couche de cuivre par dépôt électrochimique sur une couche fine de cuivre par dépôt physique en phase vapeur présente l'avantage d'offrir un coût de revient réduit. En outre le dépôt électrochimique est plus performant en cas de surfaces présentant un relief.

De manière très avantageuse, dans le cas où l'on incorpore au moins une espèce chimique dans ou sur la couche de cuivre servant au collage, il est possible d'utiliser le bain du dépôt électrochimique pour contenir les espèces chimiques. Ainsi elles sont incorporées en même temps que la couche 10 est déposée. Sur la figure 2C, l'incorporation d'espèces chimiques est schématisée par les couches 16, 116.

En variante, la deuxième couche de cuivre 10, 110 pourrait être déposée par une autre technique, parmi le dépôt physique en phase vapeur, le dépôt chimique en phase vapeur, dépôt de couches minces atomiques (ALD pour "Atomic Layer Deposition" en terminologie anglo-saxonne), et leurs variantes par assistance par plasma, faisceau d'ions, laser, sous flux de gaz à basse pression, etc.

La présente invention permet l'assemblage de surfaces comportant des motifs ou surfaces structurées, tels que représentés sur la figure 4. Par exemple, les éléments assemblés E1", E2" comportent chacun des surfaces d'assemblage comprenant des portions de cuivre 12, 112 entourées par des portions de couche de croissance par exemple TiN 14, 114, qui sont entourées par du SiOz 15, 115.

On peut par exemple réaliser des vias d'interconnexion pour l'intégration en trois dimensions. En effet, le TiN déposé par dépôt physique en phase vapeur est uniforme même dans des structures telles que des vias ayant un rapport de forme faible. Les dimensions des vias en intégration 3D sont typiquement de 5 µm à 10 µm de diamètre d pour une profondeur h de 1 à 2 µm pour un rapport de forme h/d de 1/5.

Les surfaces sont alors réalisées de sorte que les portions de cuivre ne soient pas en retrait de la surface d'assemblage par rapport au TiN et au SiO₂ de sorte que le collage direct ait lieu effectivement entre les portions de cuivre.

Grâce à l'invention, l'assemblage de cuivre offre une tenue mécanique élevée, par exemple capable de supporter tous les efforts induits par les procédés après collage, et ceci à basse température, et notamment à température ambiante.

En outre, la cinétique de renforcement est améliorée. Ainsi on obtient plus rapidement, par exemple de l'ordre de quelques jours et typiquement en moins d'une semaine, au moins la même tenue à la rupture que les assemblages de l'état de la technique. Ce gain de temps est particulièrement intéressant dans le cadre d'une fabrication industrielle.

De plus, l'assemblage peut avoir lieu à très basse température, par exemple à température ambiante, il est donc particulièrement intéressant dans le cadre de collage d'hétérostructures puisque le problème dû à la différence de dilatation thermique entre les matériaux ne se pose pas.

## Revendications

1. Procédé de réalisation d'une structure par collage direct de deux éléments comportant la réalisation des éléments à assembler et l'assemblage desdits éléments, dans lequel la réalisation des éléments à assembler comporte les étapes:
- dépôt sur un substrat semi-conducteur (2) d'au moins une portion de croissance (6) en un matériau choisi parmi TiNₓ et TaNₓ, ladite portion de croissance (6) étant déposée par dépôt physique en phase vapeur à une température comprise entre 20°C et 100°C,
- dépôt d'au moins une première portion de cuivre (8, 108) sur tout ou partie de la portion de croissance (6), les conditions de dépôt de la portion de croissance (6) par dépôt physique en phase vapeur étant telles que le rapport d'intensités des pics de cuivre (220) et (111) est supérieur ou égal à 0,5, les pics étant mesurés par diffraction RX, et
dans lequel l'assemblage desdits éléments comporte les étapes:
- polissage des surfaces des premières portions de cuivre (8, 108) destinées à venir en contact de sorte à ce qu'elles présentent une rugosité inférieure à 1 nm RMS et des propriétés hydrophiles,
- mise en contact desdites surfaces,
- stockage de ladite structure à basse température entre 0°C et 100°C.

2. Procédé de réalisation selon la revendication 1, dans lequel les conditions de dépôt de la portion de croissance (6) par dépôt physique en phase vapeur sont telles que la première portion de cuivre a une croissance favorisant les plans peu denses tels que les plans des familles (110) et (100).

3. Procédé de réalisation selon la revendication 1 ou 2, dans lequel le matériau de la portion de croissance (6) est du TiN.

4. Procédé de réalisation selon l'une des revendications 1 à 3, dans lequel le la première portion de cuivre (8, 108) est formée par dépôt physique en phase vapeur.

5. Procédé de réalisation selon l'une des revendications 1 à 4, dans lequel au moins une deuxième portion de cuivre (10, 110) est formée sur la première portion de cuivre (8, 108) d'au moins un des éléments.

6. Procédé de réalisation selon la revendication 5, dans lequel la deuxième portion de cuivre (10, 110) est formée par dépôt électrochimique, par dépôt atomique, par dépôt physique en phase vapeur, par dépôt chimique en phase vapeur.

7. Procédé de réalisation selon l'une des revendications 1 à 6, comportant une étape d'incorporation d'au moins une espèce chimique dans ou sur la première (8, 108) ou deuxième (10, 110) portion de cuivre.

8. Procédé de réalisation selon la revendication 7, dans lequel la au moins une espèce chimique est choisie parmi le bore et/ou le carbone, et/ou le phosphore et/ou le soufre et /ou le chlore et/ou l'oxygène.

9. Procédé de réalisation selon la revendication 7 ou 8, dans lequel l'incorporation d'au moins une espèce chimique se fait par dépôt, par implantation ionique ou par diffusion.

10. Procédé de réalisation selon la revendication 7, 8 ou 9, dans lequel l'incorporation d'au moins une espèce chimique a lieu pendant le polissage.

11. Procédé de réalisation selon la revendication 5 et selon l'une des revendications 7 ou 8, dans lequel la deuxième portion de cuivre (10, 110) est formée par dépôt électrochimique et l'incorporation d'espèce se fait lors du dépôt électrochimique.

12. Procédé de réalisation selon l'une des revendications 1 à 11, dans lequel le stockage se fait à une température comprise entre 75°C et 100°C et/ou dans lequel le collage se fait avec un degré d'humidité au moins égale à 20%.

13. Procédé de réalisation selon l'une des revendications 1 à 12, dans lequel la structure est une structure microélectronique et/ou nanoélectronique, les portions de cuivre formant par exemple des vias d'interconnexion.

## Patentansprüche

1. Verfahren zur Herstellung einer Struktur durch direktes Verkleben zweier Elemente, die Herstellung der zu verbindenden Elemente und das Verbinden der Elemente beinhaltend, wobei die Herstellung der zu verbindenden Elemente die Schritte beinhaltet:
- Abscheiden auf einem Halbleitersubstrat (2) von mindestens einem Wachstumsabschnitt (6) aus einem aus TiNₓ und TaNₓ ausgewählten Material, wobei der Wachstumsabschnitt (6) durch physikalische Gasphasenabscheidung bei einer Temperatur zwischen 20 °C und 100 °C abgeschieden wird,
- Abscheiden von mindestens einem ersten Kupferabschnitt (8, 108) auf dem gesamten oder einem Teil des Wachstumsabschnitts (6), wobei die Bedingungen für das Abscheiden des Wachstumsabschnitts (6) durch physikalische Gasphasenabscheidung derart sind, dass das Intensitätsverhältnis der Kupferpeaks (220) und (111) größer oder gleich 0,5 ist, wobei die Peaks durch RX-Beugung gemessen werden, und
wobei das Verbinden der Elemente die Schritte beinhaltet:
- Polieren der Oberflächen der ersten Kupferabschnitte (8, 108), die bestimmt sind, um in Kontakt zu kommen, so dass sie eine Rauheit von weniger als 1 nm RMS und hydrophile Eigenschaften aufweisen,
- In-Kontakt-Bringen der Oberflächen,
- Lagern der Struktur bei niedrigen Temperaturen zwischen 0 °C und 100 °C.

2. Herstellungsverfahren nach Anspruch 1, wobei die Bedingungen für das Abscheiden des Wachstumsabschnitts (6) durch physikalische Gasphasenabscheidung derart sind, dass der erste Kupferabschnitt ein Wachstum aufweist, das die Ebenen mit geringer Dichte wie die Ebenen der Familien (110) und (100) begünstigt.

3. Herstellungsverfahren nach Anspruch 1 oder 2, wobei das Material des Wachstumsabschnitts (6) TiN ist.

4. Herstellungsverfahren nach einem der Ansprüche 1 bis 3, wobei dererste Kupferabschnitt (8, 108) durch physikalische Gasphasenabscheidung gebildet wird.

5. Herstellungsverfahren nach einem der Ansprüche 1 bis 4, wobei mindestens ein zweiter Kupferabschnitt (10, 110) auf dem ersten Kupferabschnitt (8, 108) von mindestens einem der Elemente gebildet wird.

6. Herstellungsverfahren nach Anspruch 5, wobei der zweite Kupferabschnitt (10, 110) durch elektrochemische Abscheidung, Atomabscheidung, physikalische Gasphasenabscheidung, chemische Gasphasenabscheidung gebildet wird.

7. Herstellungsverfahren nach einem der Ansprüche 1 bis 6, einen Schritt der Inkorporation mindestens einer chemischen Spezies in oder auf dem ersten (8, 108) oder zweiten (10, 110) Kupferabschnitt beinhaltend.

8. Herstellungsverfahren nach Anspruch 7, wobei die mindestens eine chemische Spezies aus Bor und/oder Kohlenstoff und/oder Phosphor und/oder Schwefel und/oder Chlor und/oder Sauerstoff ausgewählt ist.

9. Herstellungsverfahren nach Anspruch 7 oder 8, wobei die Inkorporation mindestens einer chemischen Spezies durch Abscheidung, lonenimplantation oder Diffusion erfolgt.

10. Herstellungsverfahren nach Anspruch 7, 8 oder 9, wobei die Inkorporation mindestens einer chemischen Spezies während des Polierens stattfindet.

11. Herstellungsverfahren nach Anspruch 5 und nach einem der Ansprüche 7 oder 8, wobei der zweite Kupferabschnitt (10, 110) durch elektrochemische Abscheidung gebildet wird und die Inkorporation der Spezies während der elektrochemischen Abscheidung erfolgt.

12. Herstellungsverfahren nach einem der Ansprüche 1 bis 11, wobei das Lagern bei einer Temperatur zwischen 75 °C und 100 °C erfolgt und/oder wobei die Verklebung mit einem Feuchtigkeitsgrad von mindestens 20 % erfolgt.

13. Herstellungsverfahren nach einem der Ansprüche 1 bis 12, wobei die Struktur eine mikroelektronische und/oder eine nanoelektronische Struktur ist, wobei die Kupferabschnitte zum Beispiel Vias zur Vernetzung bilden.

## Claims

1. Method for producing a structure by the direct bonding of two elements comprising the production of the elements to be assembled and the assembly of said elements, wherein the production of the elements to be assembled comprises the following steps:
- deposition on a semi-conductor substrate (4) of at least one growth portion (6) made from a material chosen from TiNₓ and TaNₓ, said growth portion (6) being deposited by physical vapour deposition, at a temperature between 20°C and 100°C,
- deposition of at least one first portion of copper (8, 108) on all or part of the growth portion (6), the conditions for depositing the growth portion (6) by physical vapour deposition being such that the ratio between the intensities of the peaks (220) and (111) is greater than or equal to 0.5, whereby the peaks are measured by RX diffraction, and
wherein the assembly of said elements comprises the following steps:
- polishing the surfaces of the first portions of copper (8, 108) intended to come into contact so that they have a roughness of less than 1 nm RMS and hydrophilic properties,
- bringing said surfaces into contact,
- storing said structure at a low temperature at a temperature between 0°C and 100°C.

2. Production method according to claim 1, wherein the conditions for the deposition of the growth portion (6) by physical vapour deposition are such that the first portion of copper has a growth favouring the less dense planes such as the planes of families (110) and (100).

3. Production method according to claim 1 or 2, wherein the material of the growth potion (6) is TiN.

4. Production method according to one of claims 1 to 3, wherein the first portion of copper (8, 108) is formed by physical vapour deposition.

5. Production method according to one of claims 1 to 4, wherein at least one second portion of copper (10, 110) is formed on the first portion of copper (8, 108) of at least one of the elements.

6. Production method according to claim 5, wherein the second portion of copper (10, 110) is formed by electrochemical deposition, atomic deposition, physical vapour deposition or chemical vapour deposition, etc.

7. Production method according to one of claims 1 to 6, comprising a step for incorporating at least one chemical species in or on the first (8, 108) or second (10, 110) portion of copper.

8. Production method according to claim 7, wherein the at least one chemical species is chosen from boron and/or carbon, and/or phosphorus and/or sulphur and/or chlorine and/or oxygen.

9. Production method according to claim 7 or 8, wherein the incorporation of at least one chemical species takes place by deposition, by ion implantation or by diffusion.

10. Production method according to claim 7, 8 or 9, wherein the incorporation of at least one chemical species takes place during polishing.

11. Production method according to claim 5 and according to one of claims 7 or 8, wherein the second portion of copper (10, 110) is formed by electrochemical deposition and the species is incorporated during the electrochemical deposition.

12. Production method according to one of claims 1 to 11, wherein storage takes place at a temperature of between 75°C and 100°C and/or wherein bonding takes place at a humidity level at least equal to 20%.

13. Production method according to one of claims 1 to 12, wherein the structure is a microelectronic and/or nanoelectronic structure, the portions of copper forming, for example, interconnection vias.
